# EUROPEAN PATENT APPLICATION

(11) **EP 4 407 683 A1**
(43) Date of publication of application: **31.07.2024**
(21) Application number: 24153928.7
(22) Date of filing: 25.01.2024
(51) Int. Cl.: H01L 27/02, H01L 29/739, H01L 29/06, H01L 29/08, H01L 29/74

(54) **AN INSULATED-GATE BIPOLAR TRANSISTOR DEVICE AS WELL AS A DATA TRANSMISSION SYSTEM IMPLEMENTING SUCH INSULATED-GATE BIPOLAR TRANSISTOR DEVICE**

(30) Priority: 26.01.2023 EP 23153397
(71) Applicant: Nexperia B.V., 6534 AB Nijmegen (NL)
(72) Inventor: Holland, Steffen, 22529 Hamburg (DE)
(74) Representative: Pjanovic, Ilija

(57) **Abstract**

An insulated-gate bipolar transistor device comprising:
a first region doped with a first type of charge carriers;
a second region doped with a second type of charge carriers different from the first type of charge carriers;
a third region doped with the first type of charge carriers;
a fourth region doped with the second type of charge carriers;
a first, emitter terminal electrically connected with the first region and a second, collector terminal electrically connected with the third region and the fourth region; and
a gate structure disposed on the third region with one end adjacent to the second region and with another end adjacent the fourth region; as well as
a diode structure having a first diode structure terminal electrically connected with the collector terminal and a second diode structure terminal electrically connected with the gate terminal of the gate structure,
wherein the diode structure is a paired antiparallel diode structure with a total capacitance no greater than 200 femto-Farads.

## Description

### TECHNICAL FIELD

The present disclosure relates to an insulated-gate bipolar transistor device as well as a data transmission system implementing such insulated-gate bipolar transistor device. In particular, although not exclusively, the present disclosure pertains to applications involving electrostatic discharge (ESD) or electrical overstress (EOS) protection.

### BACKGROUND OF THE DISCLOSURE

Electrostatic discharge is a problem encountered in a range of electronic systems, including data transmission systems. When an ESD event occurs in a data transmission system, components of the data transmission system may be damaged if the discharge is not suitably dissipated by the system.

Semiconductor controlled rectifiers or SCRs are popular for ESD protection due to their deep snap-back and consequently low clamping voltage. The trigger voltages can be high, especially when a low capacitance is needed for proper operation. For reducing the trigger voltage, a well-known solution implements external triggering, that is using a current source with a low turn-on voltage to forward bias one emitter base junction of the SCR. For very low trigger voltages diode strings can be used for creating the necessary trigger current.

Accordingly, ESD protection devices need to have a low trigger voltage, possibly without a snapback and a low device capacitance. Open base transistors normally have a snapback, but can be tuned to low capacitance. A MOSFET has a very high capacitance (due its size). In addition, ESD protection devices are normally two pin devices, which means that the Gate terminal needs to be connected to one of the terminals, which increases the capacitance even further because of the thin gate oxide.

It is a goal of the present disclosure to provide an improved insulated-gate bipolar transistor device as well as a data transmission system implementing such insulated-gate bipolar transistor device obviating the above sketched issues.

### SUMMARY OF THE DISCLOSURE

According to a first example of the disclosure, an insulated-gate bipolar transistor device is proposed, which device comprises a first region doped with a first type of charge carriers; a second region doped with a second type of charge carriers different from the first type of charge carriers; a third region doped with the first type of charge carriers; a fourth region doped with the second type of charge carriers; a first, emitter terminal electrically connected with the first region and a second, collector terminal electrically connected with the third region and the fourth region. Furthermore, a gate structure is used, being disposed on the third region with one end adjacent to the second region and with another end adjacent the fourth region.

According to the disclosure, insulated-gate bipolar transistor device also comprises a single diode structure or an antiparallel diode structure having a first diode structure terminal electrically connected with the emitter terminal and a second diode structure terminal electrically connected with the gate terminal of the gate structure. Such insulated-gate bipolar transistor (IGBT) device can be used as a stand-alone ESD protection device or as a trigger in an ESD protection device. The low capacitance of the pair of antiparallel diode devices hides the high capacitance of the gate oxide of the gate structure. In particular, the breakdown voltage of the device can be tuned by the Vth of the MOSFET and the MOSFET avoids a voltage snapback from occurring. Furthermore, such IGBT device functions as a bipolar device and therefore it can have a higher current density than a MOSFET device. Also, the antiparallel diodes reduce the overall capacitance, which feature further adds to the use of the IGBT device as a stand-alone ESD protection device or as a trigger in an ESD protection device.

In examples of the insulated-gate bipolar transistor device according to the disclosure, the first region is formed as a well in the second region and/or the third region is formed as a well in the second region and/or the fourth region is formed as a well in the third region. Accordingly, such IGBT device can be manufactured in a logical sequence of manufacturing steps.

Additionally, the third region may comprise a low dopant region adjoining the fourth region and the gate structure, and a high dopant region adjoining second terminal, wherein the doping of the high dopant region is higher than the doping of the low dopant region. This region forms the p-body of the MOSFET and requires a MOSFET channel. The different doping allows to tune the onset of the current flow of the IGBT.

In a further example, the second region may comprise a low dopant region adjoining the first region, and a high dopant region adjoining the third region and the gate structure, wherein the doping of the high dopant region is higher than the doping of the low dopant region. The high dopant region adjoining the third region and the gate structure functions as a punch through stopper suppressing any punch through leakage from the third region towards the first region.

In an additional example, by providing a further high dopant region in the second regions, which further high dopant region adjoins the third region and the second terminal and tunes the breakdown voltage of the device.

In further beneficial examples, the first region, the third region and/or the fourth region are high dopant regions to allow low a low ohmic contact between the contacting metal and the silicon.

It is noted that in a preferred example, each diode device of the antiparallel diode structure comprises a first diode region doped with a first type of charge carriers and a second diode region doped with a second type of charge carriers, and wherein the first diode region and the second diode region are formed as a well in the second region. In particular, the first diode region and/or the second diode region are high dopant regions to allow low a low ohmic contact between the contacting metal and the silicon.

Additionally, in an example, the second region may be provided with a boundary deep trench isolation structure for each diode device of the antiparallel diode structure. Optionally, each boundary deep trench isolation structure may comprise one or more buried bottom layers.

The disclosure also pertains to a current-controlled semiconductor system comprising a signal line for carrying a signal; a ground line for connecting to ground; and a semiconductor controlled rectifier, SCR, device. The SCR device may comprise a first SCR layer doped with a first type of charge carriers; a second SCR layer doped with a second type of charge carriers different from the first type of charge carriers; a third SCR layer doped with the first type of charge carriers; a fourth SCR layer doped with the second type of charge carriers. Moreover, an input SCR terminal is electrically connected with the first SCR layer and the signal line and an output SCR terminal electrically connected with the fourth SCR layer and the ground line. According to the disclosure at least one insulated-gate bipolar transistor device according to the disclosure is provided, which is electrically connecting the signal line and the third SCR layer. In this unidirectional example, the IGBT device functions as a trigger in the ESD protection device.

In a further, bidirectional example of the current-controlled semiconductor system according to the disclosure, the system comprises a further SCR device comprising a first SCR layer doped with a first type of charge carriers; a second SCR layer doped with a second type of charge carriers different from the first type of charge carriers; a third SCR layer doped with the first type of charge carriers; a fourth SCR layer doped with the second type of charge carriers; an input SCR terminal electrically connected with the first SCR layer and the ground line as well as an output SCR terminal electrically connected with the fourth SCR layer and the signal line; as well as at least one insulated-gate bipolar transistor device according to the disclosure electrically connecting the ground line and the third SCR layer.

The disclosure also pertains to another example of a current-controlled semiconductor system comprising a signal line for carrying a signal; a ground line for connecting to ground; and a semiconductor controlled rectifier, SCR, device. The SCR device may comprise a first SCR layer doped with a first type of charge carriers; a second SCR layer doped with a second type of charge carriers different from the first type of charge carriers; a third SCR layer doped with the first type of charge carriers; a fourth SCR layer doped with the second type of charge carriers. Moreover, an input SCR terminal is electrically connected with the first SCR layer and the signal line and an output SCR terminal electrically connected with the fourth SCR layer and the ground line. According to the disclosure at least one insulated-gate bipolar transistor device according to the disclosure is provided, which is electrically connecting electrically connecting the second layer and the third SCR layer. Also in this unidirectional example, the IGBT device functions as a trigger in the ESD protection device.

It should be noted, that for both the insulated-gate bipolar transistor, IGBT, device and the current-controlled semiconductor system, that the first type of charge carriers may be P-type carriers, whereas the second type of charge carriers may be N-type carriers. However, the reversed configuration, wherein the first type of charge carriers are N-type carriers and the second type of charge carriers are P-type carriers is equally appliable in achieving the desired effect of creating one of both of the emitter base junctions having a low capacitance.

Beneficial examples as to the high doping used may include a high dopant region having a doping greater than 1×10¹⁵ cm⁻³ and a layer thickness greater than 0.2 µm, more in particular a doping greater than 1×10¹⁶ cm⁻³ and a layer thickness greater than 1 µm. Likewise, as to the low doping, the low dopant region may have a doping smaller than 1×10¹⁵ cm⁻³ and a layer thickness greater than 1 µm, more in particular a doping smaller than 1×10¹⁴ cm⁻³ and a layer thickness greater than > 2 µm.

### BRIEF DESCRIPTION OF THE DRAWINGS

The disclosure will now be discussed with reference to the drawings, which show in:
Figure 1 an overview example of a data transmission system implementing an IGBT device according to the disclosure;
Figures 2A-2B a first example of an IGBT device according to the disclosure;
Figure 2C a bidirectional example of IGBT devices according to the disclosure;
Figures 3A-3C further examples of an IGBT device according to the disclosure;
Figures 4A-4C detailed views of unidirectional examples of a data transmission system implementing an IGBT device according to the disclosure;
Figure 4D an bidirectional example of a data transmission system implementing IGBT devices according to the disclosure;
Figures 4E and 4F further bidirectional examples of a data transmission system implementing IGBT devices according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

For the sake of clarity, it is noted that in this application several examples of IGBT devices according to the disclosure are depicted, whose configuration is formed of regions or layers of one or more semiconductor materials, which materials are doped with a first type of charge carriers or with a second type of charge carriers, and wherein the second type of charge carriers are different from the first type of charge carriers.

Throughout the following detailed description it is understood, that the first type of charge carriers are P-type carriers, and the second type of charge carriers are logically N-type carriers. However, the reversed configuration, wherein the first type of charge carriers are N-type carriers and the second type of charge carriers are P-type carriers is equally appliable in all examples described in this application, as both configurations (PN or NP) achieve the desired effect of reducing the overall capacitance of the IGBT device, which feature further adds to the use of the IGBT device as a stand-alone ESD protection device or as a trigger in an ESD protection device.

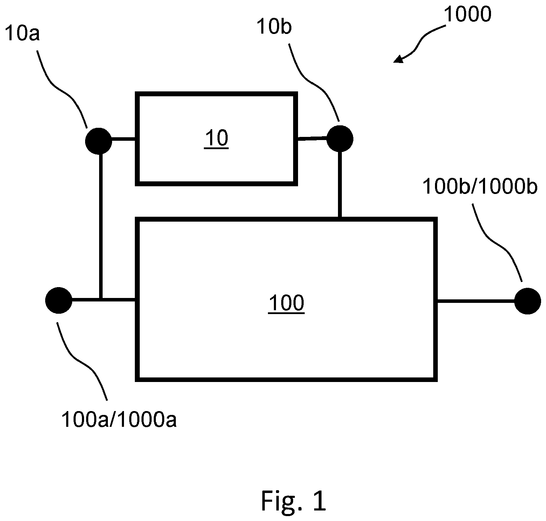

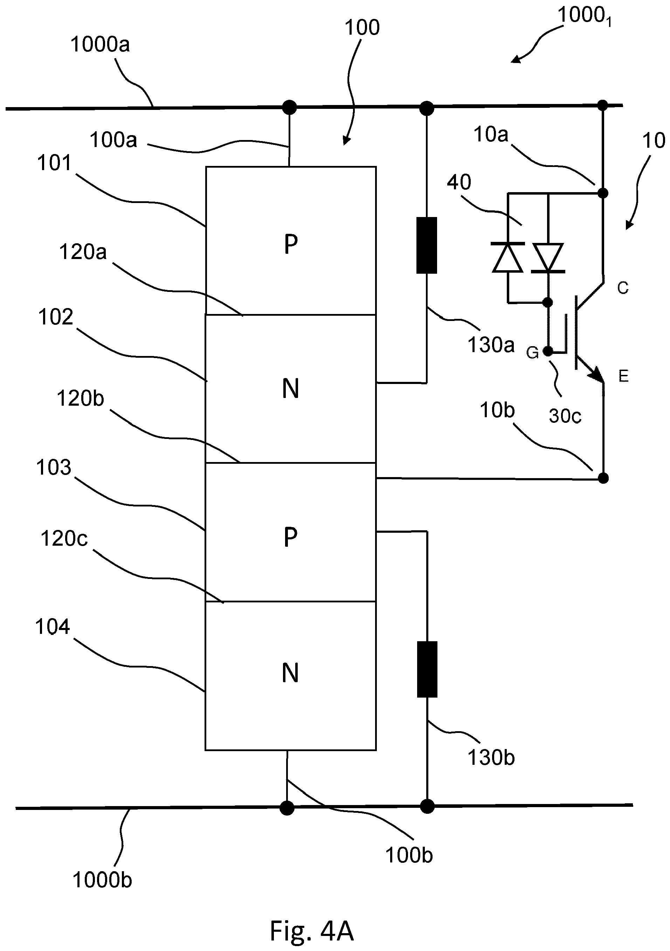

Figures 1 and 4A-4D depict examples of a data transmission system, denoted with reference numeral 1000 (1000₁-1000₄), implementing an IGBT device denoted with 10 (10-1, 10-2) according to the disclosure.

As outlined in the introduction of this application, electrostatic discharge is a problem encountered in a range of electronic systems, including data transmission systems. When an ESD event occurs in a data transmission system, components of the data transmission system may be damaged if the discharge is not suitably dissipated by the system.

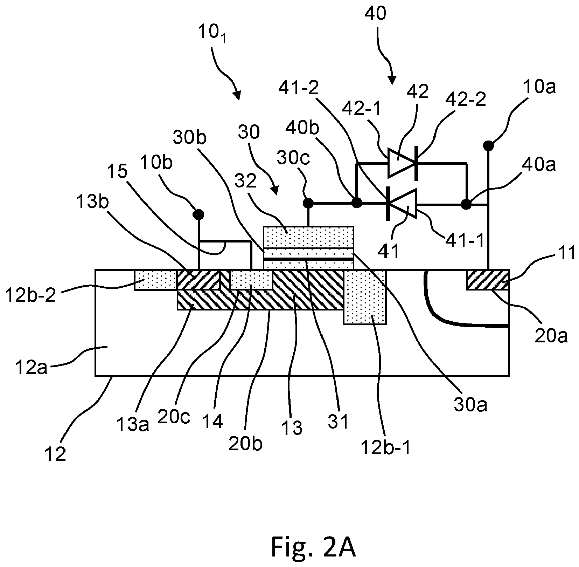

A first example of an IGBT device according to the disclosure exhibiting a low trigger voltage, no or limited a snapback and a low device capacitance is depicted in Figure 2A.

In Figure 2A, the insulated-gate bipolar transistor device is denoted with reference numeral 10, and is composed of a substrate 12. Substrate 12 functions as a base substrate for the IGBT device 10, and will be recalled throughout this application as a second region or layer 12 doped with doped a second type of charge carriers. Reference numeral 11 denotes a first layer or region of the IGBT device 10, and the first layer or region is doped with a first type of charge carriers. The first type of charge carriers are different from the second type of charge carriers.

In this particular example, the first layer/region 11 is formed as a well in the second layer/region 12, the forming of a well can be accomplished using suitable and known semiconductor manufacturing techniques.

Reference numeral 13 denotes a third layer or region, which is doped with the first type of charge carriers as the first layer/region 11. The third layer/region 13 can be equally formed as a well in the second layer/region 12 using similar suitable and known semiconductor manufacturing techniques.

The IGBT device 10₁ according to the disclosure furthermore comprises a fourth layer/region, which is doped with the second type of charge carriers, similar as the second layer/region 12. As shown in Figure 2A, The fourth layer/region 14 can be equally formed as a well in the third layer/region 13 using suitable and known semiconductor manufacturing techniques.

The first layer/region 11 forms a first junction 20a with the second layer/region 12, whereas the second layer/region 12 forms a second junction 20b with the third layer/region layer 13. Similarly, the third layer/layer 13 forms a third junction 20c with the fourth layer/region 14.

A junction element or short 15 electrically interconnects the third layer/region 13 and the fourth layer/region 14. A first, emitter terminal 10a is electrically connected with the first layer/region 11 and a second, collector terminal 10b is electrically connected with the junction element or short 15, hence with the third layer/region 13 and the fourth layer/region 14.

In all examples of the IGBT devices 10₁-10₃ according to the disclosure and depicted in this application, a gate structure 30 is provided. The gate structure 30 has a gate oxide 31 being disposed on the third region 13, such that a first end 30a of the gate structure 30 lies adjacent to or adjoins the second region 12 and that the second end 30b of the gate structure 30 lies adjacent to or adjoins the fourth region 14. In addition, the gate structure 30 is structured as a stack as it also comprises a gate material 32, e.g. a gate metal or gate non-metal material stacked on the gate oxide layer 31. The gate material 32 may be formed or comprised of a gate terminal 30c.

According to the disclosure, reference numeral 40 denotes a diode structure. The diode structure can be a single diode or structured as an antiparallel diode structure. In the example of an antiparallel diode structure, the antiparallel diode structure 40 is composed of a first diode structure terminal 40a, which is electrically connected with the collector terminal 10a as well as a second diode structure terminal 40b, which is electrically connected with the gate terminal 30c of the gate structure 30. Accordingly, this configuration of an insulated-gate bipolar transistor (IGBT) device implementing an antiparallel diode structure 40 can be used as a stand-alone ESD protection device or as a trigger in an ESD protection device.

The antiparallel diode structure 40 is composed of two diode devices 41 and 42, electrically connected in antiparallel configuration. Each diode devices 41/42 consists of a so-called p-n junction formed of first dopant regions or anodes 41-1/42-1 and second dopant region or cathodes 41-2/42-2.

In the example of a single diode structure a single diode device is implemented.

The low capacitance of the pair of antiparallel diodes hides the high capacitance of the gate oxide layer 31 of the gate structure 30. In particular, the breakdown voltage of the IGBT device 10, can be tuned by the Vth of the MOSFET and the MOSFET avoids a voltage snapback from occurring. Furthermore, such IGBT device functions as a bipolar device and therefore it can have a higher current density than a MOSFET device. Also, the antiparallel diodes 41-42 reduce the overall capacitance, which feature further adds to the use of the IGBT device as a stand-alone ESD protection device or as a trigger in an ESD protection device.

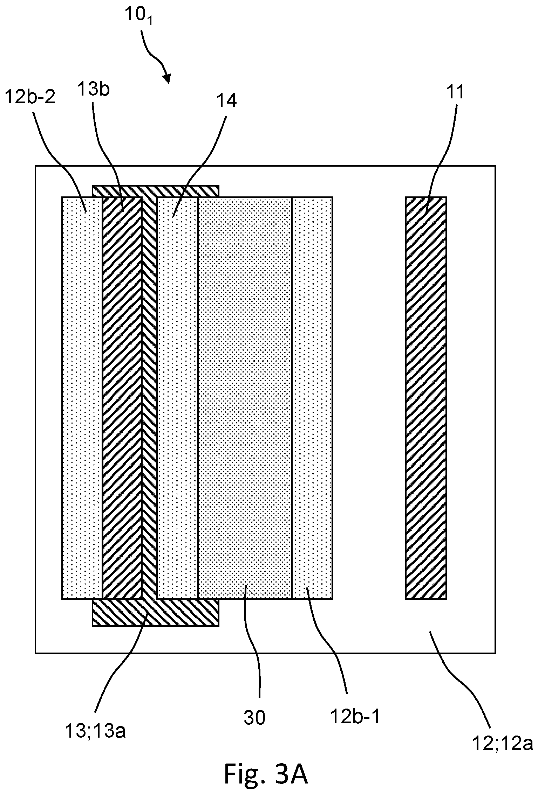

Additionally, as shown in the Figures 2A-2B, 3A-3C, the third layer or region 13 may comprise a low dopant region 13a adjoining the fourth region 14 and the gate structure 30, and a high dopant region 13b directly adjoining the second terminal 10b. The doping of the high dopant region 13b is higher than the doping of the low dopant region 13a. The low doping region acts as the substrate of the MOSFET. By its doping the threshold voltage of the MOSFET can be tuned.

Also, in an example depicted in the Figures, the second region 12 has a low dopant region 12a, which low dopant region 12a adjoins the first region 11, and at least a high dopant region 12b-1. The high dopant region 12b-1 adjoins the third region 13, and the gate structure 30 and in a particular example adjoins the low dopant region 13a of the third layer/region 13 and the first end 30a of the gate structure 30. Also here, for the second layer/region 12, the doping of the high dopant region 12b is higher than the doping of the low dopant region 12a. The high dopant region 12b adjoining the third region 13 and the gate structure 30 functions as a punch through stopper suppressing any punch through leakage from the third region 13 towards the first region 11.

A further high dopant region 12b-2 in the second region 12 can be provided, which further high dopant region 12b-2 adjoins the third region 13 and the second emitter terminal 10b. In a particular example according to the disclosure, the further high dopant region 12b-2 adjoins the high dopant region 13b of the third region 13 which directly adjoins the second emitter terminal 10b. The location of the further high dopant region 12b-2 tunes the breakdown voltage of the device.

Additionally, the first region 11 and/or the fourth region 14 are high dopant regions, which means that the dopant of the first region 11 is higher than the dopant of the corresponding third layer/region 13 (in particular higher than the dopant of the low dopant region 13a) and the dopant of the fourth region 14 is higher than the dopant of the corresponding second layer/region 12 (in particular higher than the dopant of the low dopant region 12a). The high doping regions make sure that the electrical contact resistance is low between the interface of the contact metal and the silicon.

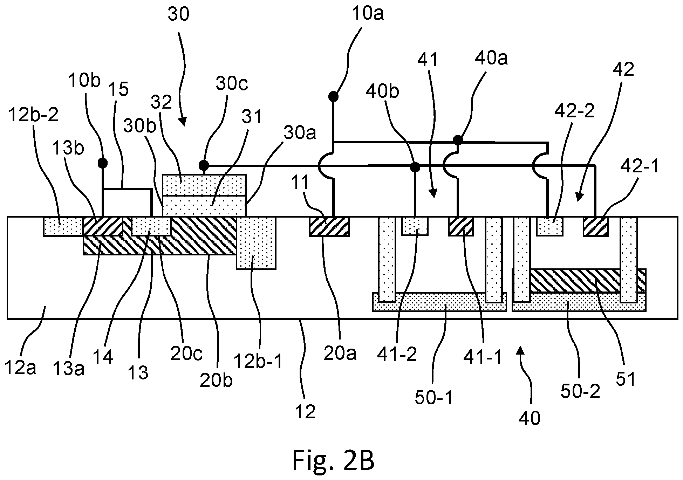

As shown in more detail in the example of Figure 2B, each diode device 41-42 of the antiparallel diode structure 40 comprises a first diode region 41-1/42-1 doped with a first type of charge carriers and a second diode region 41-2/42-2 doped with a second type of charge carriers. Both the first diode regions 41-1/42-1 and the second diode regions 41-2/42-2 may be formed as wells in the second region 12, preferably in the low dopant region 12a of the second region 12.

As the second layer/region 12 functions as a base substrate for the IGBT device 10, the wells 41-1/42-1 and 41-2/42-2 can be manufactured in a logical sequence of known manufacturing steps. Preferably, both first diode regions 41-1/42-1 and/or the second diode regions 41-2/42-2 are high dopant regions, in other words higher than the dopant of the corresponding second layer/region 12 (in particular higher than the dopant of the low dopant region 12a). This configuration enables a low junction capacitance of the diodes.

Boundary deep trench isolation structures 50-1 and 50-2 can be deposited in the substrate layer 12 (12a) for each diode device 41-42 of the antiparallel diode structure 40. Optionally, each boundary deep trench isolation structure 50-1, 50-2 may comprise one or more buried bottom layers 51. It should be noted that the isolation structures 50-1 and 40-2 can be formed as deep trenches in the substate layer 12 or by means of deep diffusion.

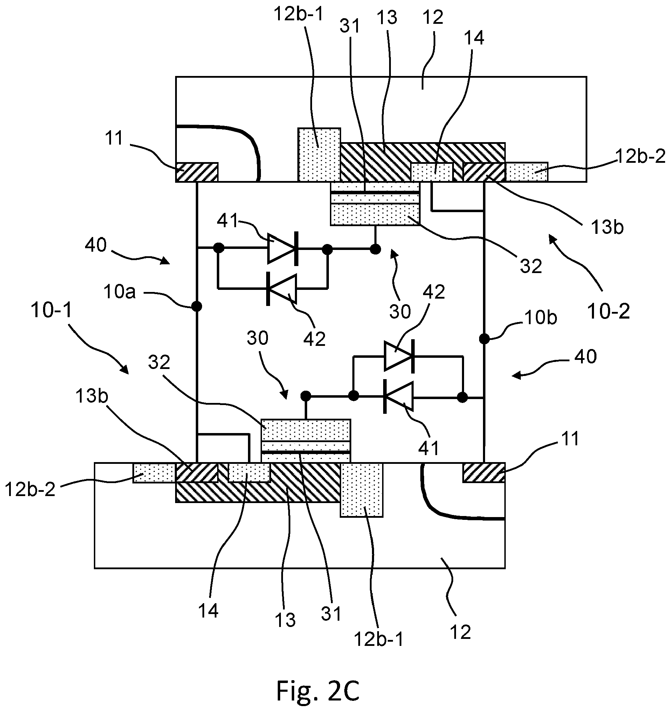

Figure 2C shows a bidirectional application of two IGBT devices 10-1 and 10-2 in a mirror configuration.

Figure 3A depicts a top view of the IGBT device 10₁ as shown in Figure 2A.

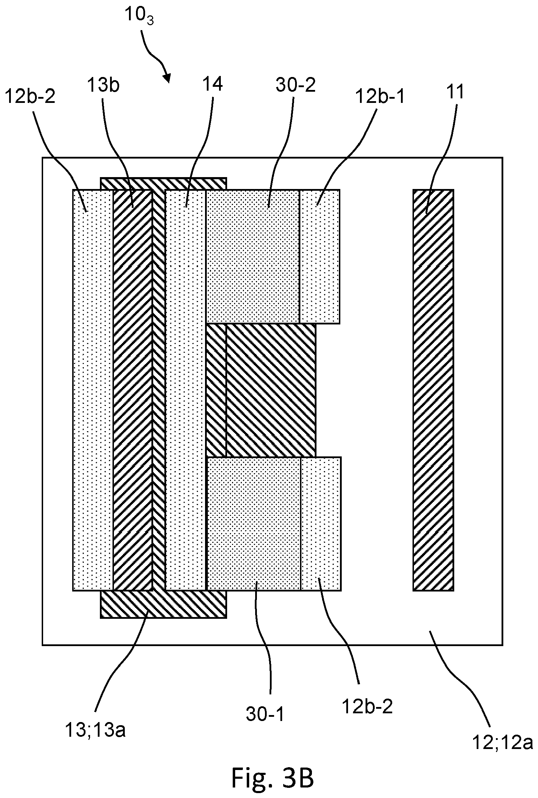

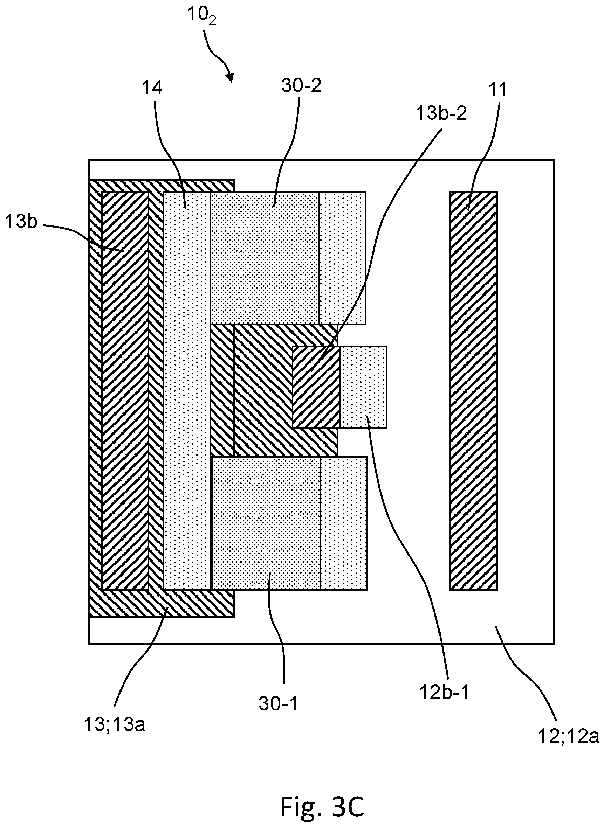

Figures 3B and 3C depict a top view of another example of an IGBT device 10₂, wherein the gate structure 30 is more localized and formed of two gate structure sections 30-1 and 30-2, reducing the depletion regions and thus limiting recombination within the IGBT device. Additionally, in Figure 3C, the further high dopant region 12b-2, which - in Figure 3B - adjoins the third region 13 and the second emitter terminal 10b is omitted, and is in Figure 3C deposited in the second region 12 between the two gate structure sections 30-1 and 30-2 and adjoins the third region 13, optionally adjoins a high dopant region 13b-2 of the third region 13.

Figure 4A shows another example of the disclosure corresponding with the example shown in Figure 1. Figure 4A depicts an unidirectional example of a current-controlled semiconductor system 1000, which comprises a signal line 1000a for carrying a signal a ground line 1000b for connecting to an electrical ground. The current-controlled semiconductor system 1000 furthermore comprises a semiconductor controlled rectifier, SCR, device, denoted with 100, being electrically connected between both signal line 1000a and ground 1000b.

The semiconductor controlled rectifier, SCR, device 100 has an input SCR terminal 100a and an output SCR terminal 100b and is composed of a configuration, e.g. a stack, of four SCR layers. The first SCR layer 101 is doped with a first type of charge carriers, in this example P-type carriers, and is electrically connected via the input SCR terminal 100a with the signal line 1000a. The first SCR layer 101 forms a first junction 120a with a second SCR layer 102, which is doped with a second type of charge carriers N, different from the first type of charge carriers P.

The semiconductor controlled rectifier, SCR, device 100 also comprises a third SCR layer 103, which doped with the first type of P-type charge carriers and the third SCR layer 103 forms a second junction 120b with the second SCR layer 102. A fourth SCR layer 104 doped with the second type of N-type charge carriers forms a third junction with the third SCR layer 103. The fourth SCR layer 104 is also electrically connected with the ground line 1000b by means of the output SCR terminal 100b.

Reference numerals 130a and 130b denote first and second SCR junction elements. The first SCR junction element 130a electrically connects the second SCR layer 102 with the signal line 100a. Likewise, the second SCR junction element 130b electrically connect the third SCR layer 103 with the ground line 100b.

In all configurations, the first and second SCR junction elements 130a and 130b comprises a resistor.

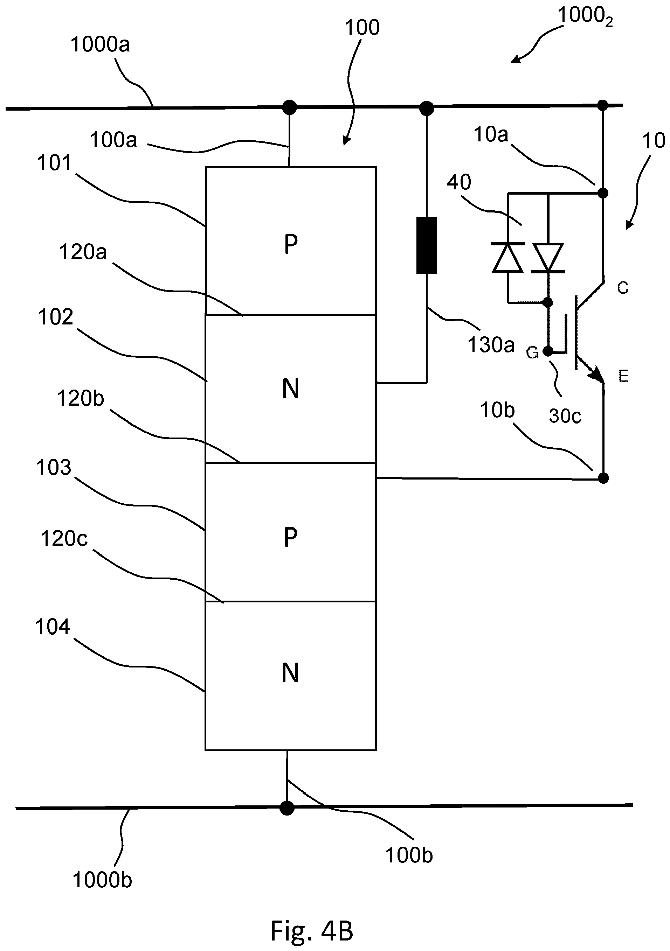

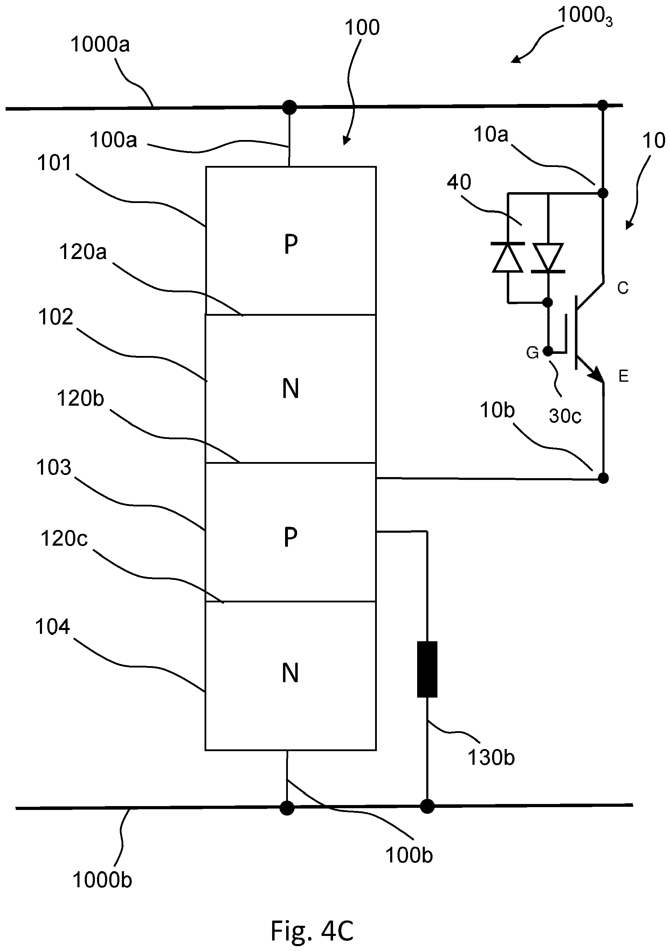

The configuration example of system 1000, of Figure 4A depicts the semiconductor controlled rectifier, SCR, device 100 with both the second and third SCR layers 102 and 103 being electrically connected via a first and a second SCR junction element 130a and 130b with the signal line 1000a and ground line 1000b, respectively. However, also configurations with only one SCR junction element are feasible, such as the second SCR layer 102 being electrically connected via the first SCR junction element 130a with the signal line 1000a (example of system 1000₂ of Figure 4B) or the third SCR layer 103 being electrically connected via the second SCR junction element 130b with the ground line 1000b (example of system 1000₃ of Figure 4C).

Additionally, in all unidirectional configurations of the current-controlled semiconductor system 1000₁-1000₂-1000₃ shown in Figures 4A-4C, it furthermore comprises at least one IGBT device 10 according to the disclosure. In the examples of Figures 4A-4C, the at least one IGBT device 10 electrically connects the signal line 1000a with the third SCR layer 103. The at least one IGBT device 10 has an input terminal 10a connected with the signal line 1000a and an output terminal 10b electrically connected with the third SCR layer 103.

In these unidirectional examples, the IGBT device 10 functions as a trigger in the ESD protection device 100.

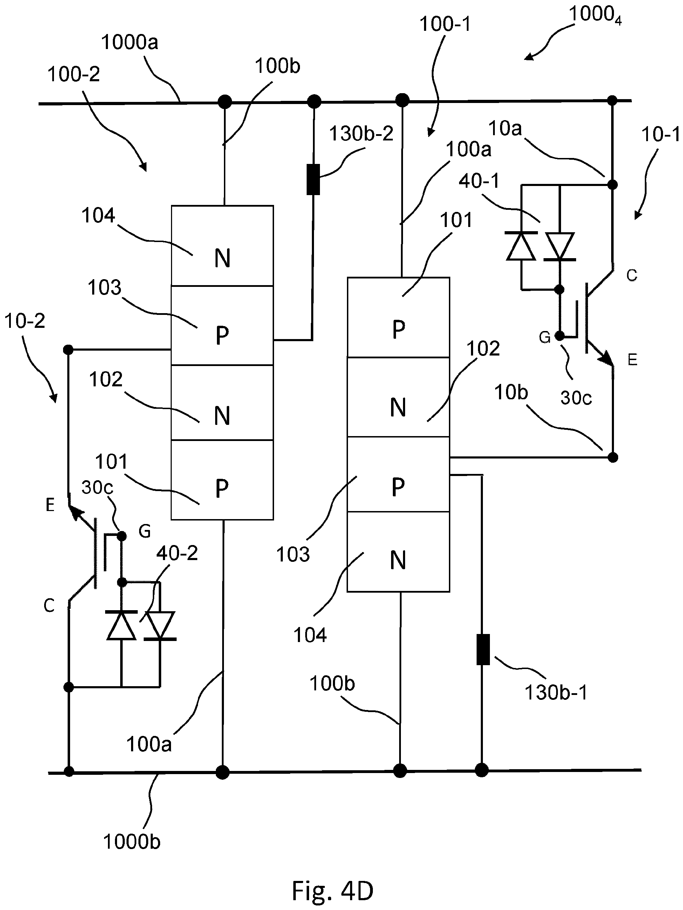

A bidirectional example of the current-controlled semiconductor system 1000₄ according to the disclosure is shown in Figure 4D. Next to the configuration shown in Figure 4C, with one SCR device 100 and one IGBT device 10, the system 1000₄ of Figure 4D comprises two, yet mirrored combinations of a SCR device 100-1 (100-2) and a IGBT device 10-1 (10-2). The further SCR device 100-2 also comprises a first SCR layer 101 doped with a first type of charge carriers; a second SCR layer 102 doped with a second type of charge carriers different from the first type of charge carriers; a third SCR layer 103 doped with the first type of charge carriers; and a fourth SCR layer 104 doped with the second type of charge carriers.

However, the assembly of SCR device 100-2 and IGBT device 10-2 is mirrored, as the input SCR terminal 100a of the SCR device 100-2 is electrically connected with the first SCR layer 101 and the ground line 1000b. Also the output SCR terminal 100b of the SCR device 100-2 is electrically connected with the fourth SCR layer 104 and the signal line 1000a. Similarly, the further insulated-gate bipolar transistor, IGBT, device 100-2 is electrically connecting the ground line 1000b with the third SCR layer 103.

In this bidirectional example, each IGBT device 10-1, 10-2 functions as a trigger in the corresponding ESD protection device 100-1, 100-2 depending on the polarity of the signal applied on either signal line 1000a or ground line 1000b.

It should be noted, that for both the insulated-gate bipolar transistor, IGBT, device and the current-controlled semiconductor system, that the first type of charge carriers may be P-type carriers, whereas the second type of charge carriers may be N-type carriers. However, the reversed configuration, wherein the first type of charge carriers are N-type carriers and the second type of charge carriers are P-type carriers is equally appliable in achieving the desired effect of creating one of both of the emitter base junctions having a low capacitance.

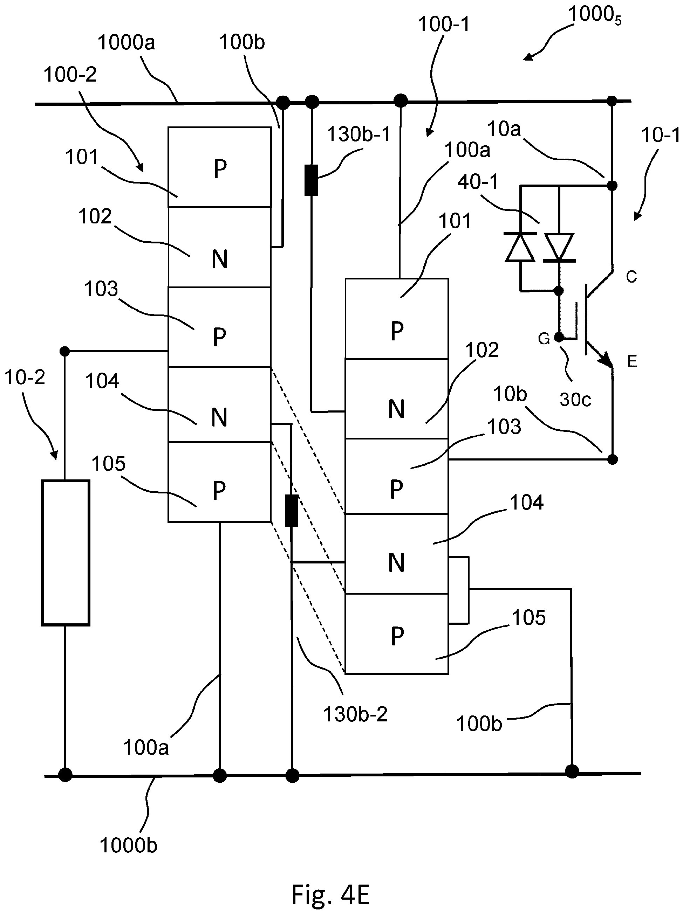

A further bidirectional example of the current-controlled semiconductor system 1000₅ according to the disclosure is shown in Figure 4E. Next to the configuration shown in Figure 4C, with one SCR device 100 and one IGBT device 10, the system 1000s of Figure 4E comprises two, yet mirrored combinations of a SCR device 100-1 (100-2) and one IGBT device 10-1. Both SCR devices 100-1 and 100-2 comprise a first SCR layer 101 doped with a first type of charge carriers; a second SCR layer 102 doped with a second type of charge carriers different from the first type of charge carriers; a third SCR layer 103 doped with the first type of charge carriers; and a fourth SCR layer 104 doped with the second type of charge carriers. Also a fifth SCR layer 105 doped with the first type of charge carriers is present.

Preferably, the fourth SCR layers 104 of both SCR devices 100-1 and 100-2 are formed as a single, joined region, and the same applies to the fifth SCR layer 105 of both SCR devices 100-1 and 100-2, as is shown by means of the dashed interconnecting lines in Figure 4E.

In the first SCR device 100-1, the input SCR terminal 100a is electrically connected with the first SCR layer 101 and the signal line 1000a. A SCR junction element 130b-1 electrically connects the second SCR layer 102 with the signal line 100a, and the fourth SCR layer 104 and the fifth SCR layer 105 are interconnected with each other via a short and connected via the output SCR terminal 100b with the ground line 1000b. The IGBT device 10-1 is electrically connecting the signal line 1000a with the third SCR layer 103.

In the mirrored second SCR device 100-2, the input SCR terminal 100a is electrically connected with the fifth SCR layer 105 and the ground line 1000b, and the output SCR terminal 100b of the second SCR device 100-2 is electrically connected with the second SCR layer 102 and the signal line 1000a. A junction element 10-2 electrically connects the third SCR layer 103 with the ground line 1000b, and the fourth SCR layer 104 is electrically connected with the ground line 1000b via a SCR junction element 130b-2, which may be a resistor. Note, that that the junction element 10-2 is different than the IGBT device 10-1 used for the first SCR device 100-1.

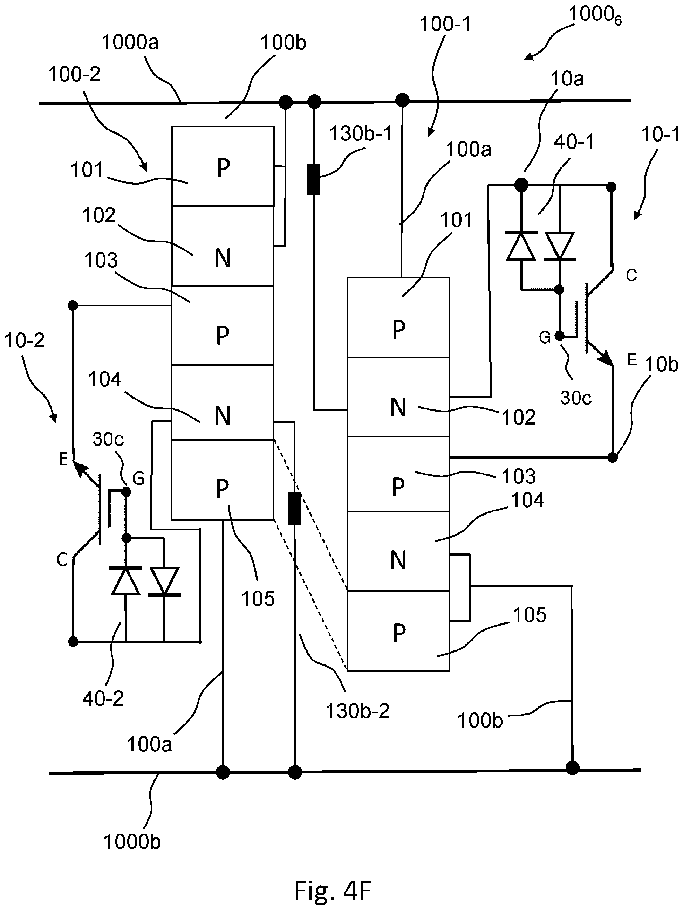

A further bidirectional example of the current-controlled semiconductor system 1000₆ according to the disclosure is shown in Figure 4F. More or less similar to the configuration shown in Figure 4E, the system 1000₆ of Figure 4F comprises two mirrored combinations of a SCR device 100-1 (100-2), and each also provided with an IGBT device 10-1 (10-2). As in Figure 4E, also in Figure 4F, both SCR devices 100-1 and 100-2 comprise a first SCR layer 101 doped with a first type of charge carriers; a second SCR layer 102 doped with a second type of charge carriers different from the first type of charge carriers; a third SCR layer 103 doped with the first type of charge carriers; and a fourth SCR layer 104 doped with the second type of charge carriers. Also a fifth SCR layer 105 doped with the first type of charge carriers is present.

Contrary to the example shown in Figure 4E, in this example of Figure 4F, the fifth SCR layers 105 of both SCR devices 100-1 and 100-2 are formed as a single, joined region, as is shown by means of the dashed interconnecting lines in Figure 4F.

In the first SCR device 100-1, the input SCR terminal 100a is electrically connected with the first SCR layer 101 and the signal line 1000a. A SCR junction element 130b-1 electrically connects the second SCR layer 102 with the signal line 100a, and the fourth SCR layer 104 and the fifth SCR layer 105 are interconnected with each other via a short and connected via the output SCR terminal 100b with the ground line 1000b. The IGBT device 10-1 is electrically connecting the second SCR layer 102 with the third SCR layer 103.

In the mirrored second SCR device 100-2, the input SCR terminal 100a is electrically connected with the fifth SCR layer 105 and the ground line 1000b, and the output SCR terminal 100b of the second SCR device 100-2 is electrically connected with both the first SCR layer 101 and the second SCR layer 102 as well as with the signal line 1000a. The IGBT device 10-2 is electrically connecting the third SCR layer 103 with the fourth SCR layer 104. The fourth SCR layer 104 is also electrically connected with the ground line 1000b via a SCR junction element 130b-2, which may be a resistor.

Beneficial examples as to the high doping used may include a high dopant region having a doping greater than 1×10¹⁵ cm⁻³ and a layer thickness greater than 0.2 µm, more in particular a doping greater than 1×10¹⁶ cm⁻³ and a layer thickness greater than 1 µm. Likewise, as to the low doping, the low dopant region may have a doping smaller than 1×10¹⁵ cm⁻³ and a layer thickness greater than 1 µm, more in particular a doping smaller than 1×10¹⁴ cm⁻³ and a layer thickness greater than > 2 µm.

In accordance with another embodiment of the present invention, the low capacitance of the pair of anti-parallel diodes refers to said pair of antiparallel diodes having a total capacitance less than equal to 200 femto-Farads (fF). Preferably, each antiparallel diode (in the pair of antiparallel diodes) has a capacitance of less than or equal to 100 fF, more preferably less than or equal to 50fF and even more preferably less than or equal to 25 fF or less than or equal to 5 fF. The low capacitance of the pair of antiparallel diode devices hides the high capacitance of the gate oxide of the gate structure. For ESD protection, a pair of antiparallel diodes of with total capacitance of 200 fF can withstand a 50A current for 1 nanoseconds.

The motivation behind hiding the high capacitance of the gate oxide of the gate structure is as follows. If one connects the gate of the IGBT directly to the voltage source, the gate capacitance of the IGBT would be effective on the signal line. This capacitively connects the signal line to the voltage source, resulting in unwanted parasitic capacitance. This parasitic capacitance load on the signal line would affect data transfer. The effects of this parasitic capacitance can be prevented by 'hiding' the gate capacitance behind the low capacity antiparallel diodes.

Such low capacitances allows for smaller sizing of the antiparallel diodes, as only a small current (in the milli Ampere range) needs to flow through these diodes. With a gate capacitance in the pico-Farad range, the charge necessary for such gate capacitance will be in the range of around 1×10⁻¹⁰ to 1 × 10⁻¹² Coulombs. For a switching time of 1 nanoseconds, the current through these diodes will be in the milliAmpere range, far below the upper limits for use in ESD protection as mentioned above. At this range, the parasitic capacitance is dominated by the remaining components of the circuits, such as the wires.

### LIST OF REFERENCE NUMERALS USED

- 10, 10₁-10₃: insulated-gate bipolar transistor device (1^{st}-3^{rd} example of the disclosure)
- 10a: first (collector) terminal
- 10b: second (emitter) terminal
- 11: first region
- 12: second region
- 12a: low dopant region of second region
- 12b-1/12b-2: high dopant region of second region
- 13: third region
- 13a: low dopant region of third region
- 13b: high dopant region of third region
- 14: fourth region
- 15: junction element / short
- 20a-20c: first, second and third junction interface
- 30: gate structure
- 30a-30b: first/second end of gate structure
- 30c: gate terminal
- 31: gate oxide
- 32: gate material
- 40: antiparallel diode structure
- 40a: first diode structure terminal
- 40b: second diode structure terminal
- 41/42: first/second diode device
- 41-1/42-1: first dopant region of first/second diode device
- 41-2/42-2: second dopant region of first/second diode device
- 50-1/50-2: first/second boundary deep trench isolation structure
- 51: buried bottom layer
- 1000: current-controlled semiconductor system (according to the disclosure)
- 1000a: signal line
- 1000b: ground line
- 100: semiconductor controlled rectifier, SCR, device
- 100a: input SCR terminal
- 100b: output SCR terminal
- 101: first SCR layer
- 102: second SCR layer
- 103: third SCR layer
- 104: fourth SCR layer
- 120a/b/c: first, second and third SCR junction interface
- 130a: first SCR junction element
- 130b: second SCR junction element

## Claims

1. An insulated-gate bipolar transistor device comprising:
a first region doped with a first type of charge carriers;
a second region doped with a second type of charge carriers different from the first type of charge carriers;
a third region doped with the first type of charge carriers;
a fourth region doped with the second type of charge carriers;
a first, emitter terminal electrically connected with the first region and a second, collector terminal electrically connected with the third region and the fourth region; and
a gate structure disposed on the third region with one end adjacent to the second region and with another end adjacent the fourth region; as well as
a diode structure having a first diode structure terminal electrically connected with the collector terminal and a second diode structure terminal electrically connected with the gate terminal of the gate structure,
wherein the diode structure is a single diode structure or an antiparallel diode structure,
wherein the diode structure is a paired antiparallel diode structure with a total capacitance no greater than 200 femto-Farads.

2. The insulated-gate bipolar transistor device according to claim 1, wherein the total capacitance of the paired antiparallel diode is no greater than 100 femto-Farads.

3. The insulated-gate bipolar transistor device according to any of the preceding claims, wherein the total capacitance of the paired antiparallel diode is no greater than 50 femto-Farads.

4. The insulated-gate bipolar transistor device according to any of the preceding claims, wherein the total capacitance of the paired antiparallel diode is no greater than 10 femto-Farads.

5. A current-controlled semiconductor system comprising:
a signal line for carrying a signal;
a ground line for connecting to ground; and
at least one semiconductor controlled rectifier, SCR, device, the at least one SCR device comprising:
a first SCR layer doped with a first type of charge carriers;
a second SCR layer doped with a second type of charge carriers different from the first type of charge carriers;
a third SCR layer doped with the first type of charge carriers;
a fourth SCR layer doped with the second type of charge carriers;
an input SCR terminal electrically connected with the first SCR layer and the signal line as well as an output SCR terminal electrically connected with the fourth SCR layer and the ground line; as well as at least one insulated-gate bipolar transistor device according to any one or more of the claims 1-4 electrically connecting the signal line and the third SCR layer,
wherein the diode structure of the at least one insulated-gate bipolar transistor device according to any one or more of the claims 1 - 4 is a paired antiparallel diode structure with a total capacitance no greater than 200 femto-Farads.

6. The current-controlled semiconductor system of claim 5 wherein the total capacitance of the paired antiparallel diode is no greater than 100 femto-Farads.

7. The insulated-gate bipolar transistor device according to any of claims 5 and 6, wherein the total capacitance of the paired antiparallel diode is no greater than 50 femto-Farads.

8. The insulated-gate bipolar transistor device according to any claims 5 to 7, wherein the total capacitance of the paired antiparallel diode is no greater than 10 femto-Farads.

9. A current-controlled semiconductor system according to claim 5, further comprising:
a further SCR device comprising a first SCR layer doped with a first type of charge carriers;
a second SCR layer doped with a second type of charge carriers different from the first type of charge carriers;
a third SCR layer doped with the first type of charge carriers;
a fourth SCR layer doped with the second type of charge carriers;
an input SCR terminal electrically connected with the first SCR layer and the ground line as well as an output SCR terminal electrically connected with the fourth SCR layer and the signal line; as well as at least one insulated-gate bipolar transistor device according to any one or more of the claims 1-4 electrically connecting the ground line and the third SCR layer,
wherein the diode structure of the at least one insulated-gate bipolar transistor device according to any one or more of the claims 1 - 4 is a paired antiparallel diode structure with a total capacitance no greater than 200 femto-Farads.

10. The current-controlled semiconductor system of claim 9 wherein the total capacitance of the paired antiparallel diode is no greater than 100 femto-Farads.

11. The insulated-gate bipolar transistor device according to any of claims 9 and 10, wherein the total capacitance of the paired antiparallel diode is no greater than 50 femto-Farads.

12. The insulated-gate bipolar transistor device according to any claims 9 to 11, wherein the total capacitance of the paired antiparallel diode is no greater than 10 femto-Farads.
